# EUROPEAN PATENT SPECIFICATION

(11) **EP 1 774 562 B1**
(45) Date of publication and mention of the grant of the patent: **22.02.2012**
(21) Application number: 05739735.8
(22) Date of filing: 22.04.2005
(51) Int. Cl.: H01J 37/32, C23C 16/44, C23C 16/455, C23C 16/503, C23C 16/513

(54) **SYSTEM FOR LOW-ENERGY PLASMA-ENHANCED CHEMICAL VAPOR DEPOSITION**
SYSTEM ZUR PLASMAUNTERSTÜTZTEN CHEMISCHEN AUFDAMPFUNG BEI NIEDRIGEN ENERGIEN
SYSTEME DE DEPOT CHIMIQUE EN PHASE VAPEUR ACTIVE PAR PLASMA DE FAIBLE ENERGIE

(30) Priority: 08.06.2004 US 578191 P; 24.11.2004 US 630209 P
(43) Date of publication of application: 18.04.2007
(73) Proprietor: Dichroic cell s.r.l., 35128 Padova (IT)
(72) Inventor: VON KAENEL, Hans, CH-8046 Zurich (CH); HAID, Reinhard, A-6706 Bürs (AT)
(74) Representative: Vinci, Marcello
(86) International application number: PCT/IB2005/001104
(87) International publication number: WO 2006/000846

(56) References cited:
- EP-A- 0 272 140
- EP-A- 0 711 847
- WO-A-02/068710
- US-A- 5 478 403
- US-A- 5 478 403
- US-A- 5 554 222
- US-A- 5 554 222
- US-A1- 2003 005 879
- GOULDING M R: "THE SELECTIVE EPITAXIAL GROWTH OF SILICON" MATERIALS SCIENCE AND ENGINEERING B, ELSEVIER SEQUOIA, LAUSANNE, CH, vol. B17, no. 1 / 3, 28 February 1993 (1993-02-28), pages 47-67, XP000359709 ISSN: 0921-5107
- BAERT K ET AL: "SELECTIVE SI EPITAXIAL GROWTH BY PLASMA-ENHANCED CHEMICAL VAPOR DEPOSITION AT VERY LOW TEMPERATURE" APPLIED PHYSICS LETTERS, AMERICAN INSTITUTE OF PHYSICS. NEW YORK, US, vol. 60, no. 4, 27 January 1992 (1992-01-27), pages 442-444, XP000305290 ISSN: 0003-6951 cited in the application

## Description

### Background of the invention

The invention relates to a reactor and process for epitaxial deposition and reactor chamber cleaning.

Chemical vapor deposition (CVD) has been the main industrial process used for the fabrication of epitaxial semiconductor layers for many decades. There are many different reactor designs in use, depending mainly on materials and operating pressure. For the epitaxy of Si and Si-compatible materials, such as SiGe, one main trend can be discerned, namely the trend towards lower processing temperatures, allowing steeper doping profiles, strained layers and smoother surfaces. For other materials such as GaN and SiC, the thermal mismatch with the Si substrate is a major concern, especially at high substrate temperatures during growth (see for example Tsubouchi et al., Appl. Phys. Lett. 77, 654 (2000) ).

Lowering of substrate temperatures has a major effect on the growth kinetics in CVD, which becomes limited by surface processes rather than gas phase transport (see for example Hartmann et al., J. Cryst. Growth 236, 10 (2002) ).

One way to overcome these limitations is to no longer rely on pure thermal decomposition of gaseous precursors, as is the case in CVD. Plasma enhanced CVD may offer such an opportunity, where a plasma discharge is used to activate the precursors such as silane (see for example CH-Patent no. 664 768 A5 to Bergmann et al. ). In this approach, an arc discharge between a hot cathode kept near ground potential and a positively biased anode in the reactor chamber have been used to produce a high density plasma discharge. In addition, a negative bias voltage of up to 610 V was applied to the substrates during layer deposition.

Great care has, however, to be exerted when using plasmas for enhanced rate of growth, since energetic particles impinging on the substrate may cause damage of the growing film. Ion energies in the plasma have therefore to be kept below the threshold for causing damage. A method for producing such a low-energy plasma has been described for example in US Patent no. 6,454,855 to von Känel et al., and in the European Patent application no. 04004051.1-2119 to von Känel et al. The method is also based on a low-voltage arc discharge which is sustained by a hot cathode located in a plasma chamber attached to the growth module. The process and apparatus for generating such a low-voltage arc discharge has been described for example in US Patent no. 5,384,018 to Ramm et al. The application of the method to the fabrication of defect-free epitaxial layers has been described also in US Patent no. 6,454,855 to von Känel et al., and in the US Patent Applications no. 0005879 to von Känel et al., as well as 0160620 to Wagner et al [sic]_{.}

The previous art has, however, met serious obstacles in the attempt to scale the equipment to 200 and 300 mm substrate sizes as required for industrial processes. One problem lies in the plasma source with its hot cathode which should not result in any contamination of the growing films. It has been shown in previous art that epitaxial growth rates above 5 nm/s are possible in a reactor suitable for 100 mm substrate size (see for example European Patent Application no. 1 315 199 A1 by von Känel et al. ). Growth rates of this kind require the plasma density in the arc to be very high in order to avoid saturation effects as a function of reactive gas flow.

Increasing the substrate size while maintaining the plasma density across the entire wafer means that a higher arc current has to be delivered by the plasma source. With a construction like the one described in US Patent no. 5,384,018 and in EP 1 315 199 A1, the arc current can be raised either by increasing the cathode temperature or the arc voltage. In the present embodiments, the cathode consists, however, for example of a Ta filament which will exhibit a vapor pressure exceeding 10⁻¹⁰ mbar when heated above approximately 1700° C. At a filament temperature of 2200° C, the vapor pressure amounts to approximately 10⁻⁶ mbar already. Since an evaporating cathode is likely to cause metal contamination in the growing film, its temperature evidently needs to be limited. Tungsten filaments are stable to higher temperatures but need to be doped for example with a rare earth element in order to reduce the work function and hence the operating temperature. Surface segregated dopant is, however, likely to evaporate at much lower temperatures than the base material itself, thus resulting again in unacceptable metal contamination.

On the other hand, increasing the arc current by increasing the arc voltage has been the preferred solution in prior art, where the issue of ion bombardment was less serious since the deposited layers did not have to be epitaxial (see for example CH-Patent no. 664 768 A5 to Bergmann et al. ). There, the conditions of a low-voltage arc discharge were defined to apply for arc voltages below 150 V and currents of at least 30 A. Under these less stringent conditions arc voltages are permissible which exceed the sputter threshold of all elements. For Si epitaxy, however, sputtering of the cathode and other metallic elements has to be prevented entirely if the material is to be suitable for electronic applications. This means that even an arc voltage of 40 V at a current of 90 A, as stated for example in US Patent no. 5,384,018 to Ramm et al., is too high in view of the sputter threshold of Ta of approximately 20 eV.

A significant problem of prior art is the poor thickness uniformity, caused by a point-like plasma source and comparatively small anode opening (see for example US patent no. 6,454,855 to von Känel et al. ). Apart from that, the 100 mm system shows an excellent performance, as proven by numerous respected researchers (see for example European Patent Application no. 1 315 199 A1 by von Känel et al., and Enciso-Aquilar et al., in El. Lett. 39, 149 (2003), as well as Rössner et al., in Appl. Phys. Lett. 84, 3058 (2004) ).

For substrate sizes of 200 mm and more thickness uniformity is even more difficult to achieve with a point-like plasma source, as is also apparent from the international patent application No. WO 02/068710 by Wagner et al. The problem to be addressed in the present invention is how scaling to a substrate size of 300 mm has to be implemented in such a way as to preserve the excellent performance (in particular growth rates) of the 100 mm system, while reaching simultaneously the thickness uniformity required for industrial systems. In addition, arc voltages have to be kept in a range similar to that of smaller systems, and the stability of the plasma discharge must not be jeopardized upon the introduction of reactive gases, such as silane and germane.

A further problem of prior art is adequate chamber cleaning in order to attain low levels of particulate contamination. Plasma cleaning of CVD chambers is a standard process, as described for example by Raoux et al. in J. Vac. Sci. Technol. B 17, 477 (1999). Cleaning of a low-energy plasma-enhanced chemical vapor deposition (LEPECVD) reactor of the kind for example described in European Patent application EP1424405 to von Känel et al. is, however, complicated by materials compatibility issues. Here, for example the presence of an anode in the reactor chamber, and refractory metal shields in the plasma source, are essential for the process to work (see for example European Patent application no. EP1 315 199 A1 by von Känel ). Such components tend to be corroded by reactive gases, such as NF₃, customarily used for the cleaning of CVD chambers.

A related problem is selective epitaxial growth which is standard in CVD, and for which gases containing halogen atoms are being used (see for example Goulding, Mat. Sci. Eng. B 17, 47 (1993) ). Plasmas containing these species, such as for example Cl, will react with the materials used in prior art LEPECVD reactors, and must therefore be excluded when contamination of the epitaxial layers is to be avoided. Selective epitaxy by plasma-enhanced CVD using conventional equipment has been described for example by Baert et al., Appl. Phys. Lett. 60, 442 (1991).

### Summary of the invention

A system for low-energy plasma-enhanced chemical vapor deposition according to the present invention is defined in claim 1. Such system includes a low-energy plasma source, deposition / reactor chamber (for single wafer processing) and gas distribution system for semiconductor epitaxy on substrates up to 300 mm in size, is described. The system allows for fast switching from high to low deposition rates, and film thickness control at the monolayer level. It incorporates chamber self-cleaning and the provisions for selective epitaxial growth.

An object of the invention is to provide a plasma source capable of generating a very low-voltage, high current arc discharge, without the need to use excessive cathode temperatures.

Another object of the invention is to provide a plasma source capable of a homogeneous plasma density and electron temperature across a substrate up to 300 mm in size.

Another object of the invention is to provide an anode geometry allowing for stable high-current discharge in the presence of reactive gases.

Another object of the invention is to provide a plasma-source/anode combination suitable also for application in low-energy ion implantation.

Another object of the invention is to provide an LEPECVD process for epitaxial semiconductor deposition compatible with the process of reactor chamber cleaning.

Another object of the invention is to provide a system which allows for use of halogenated precursors in an LEPECVD process.

Another object of the invention is to provide a low-energy plasma for surface treatment processes.

### Brief description of the drawings

FIG. 1 is a schematic diagram of an LEPECVD system comprising plasma source and deposition chamber (note that the plasma source is electrically insulated from the deposition chamber).
FIG. 2A and 2B show top and side views of the filament flange of the plasma source having three thermionic cathodes with 3 independently addressable filaments.
FIG. 3 is a graph of the current- voltage characteristics of a low-voltage arc discharge for a pure Ar plasma with hot cathodes made from one or two Ta filaments.
FIG. 4 is a schematic diagram of a plasma source cover in the form of a showerhead.
FIG. 5 is a graph comparing the floating potential of a Langmuir probe along a line perpendicular to the plasma column measured in a 100 mm system with single orifice and a 200 mm system with showerhead.
FIG. 6A and 6B are top views of two variants of possible anodes permeable to the plasma.
FIG. 7 is a graph showing the influence of silane flow on the arc voltage for perforated anode and a plasma source with shower head.
FIG. 8 is a graph showing the arc current-voltage characteristics for three filaments operated simultaneously and for two set-ups with differing magnetic field confinement.
FIG. 9A and 9B are graphs showing the thickness variation of a Si film measured along two perpendicular directions on a 200 mm wafer.
FIG. 10 is a schematic diagram of the gas supply diagram showing gas supply lines suitable for fast switching.
FIG. 11 is a transmission electron microscopy image of part of a short-period Si/Ge superlattice grown by LEPECVD.
FIG. 12 is a graphical representation of an ω-2θ X-ray scan around the (004) reflection of a short-period Si/Ge superlattice grown by LEPECVD.
FIG. 13A and 13B are schematic diagrams showing substrate temperature and mass flows for dichlorosilane and HCl as a function of time for continuous and pulsed modes, respectively.

### Detailed Description of the Preferred Embodiment(s):

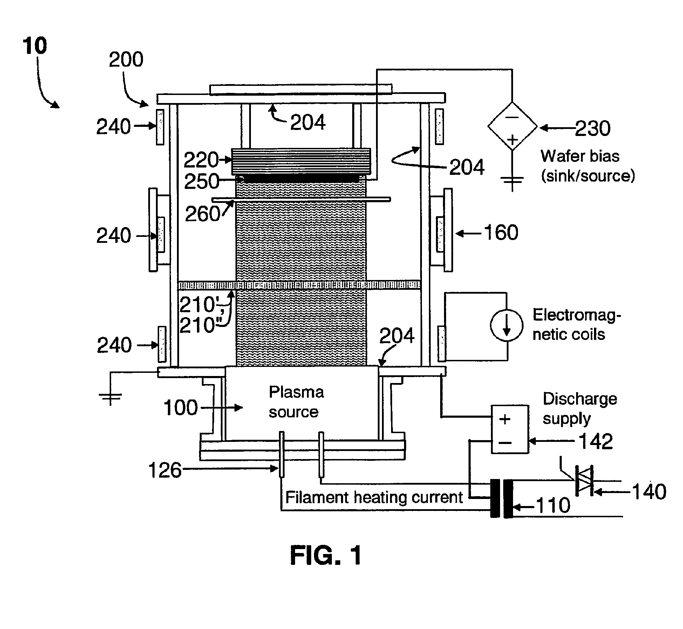

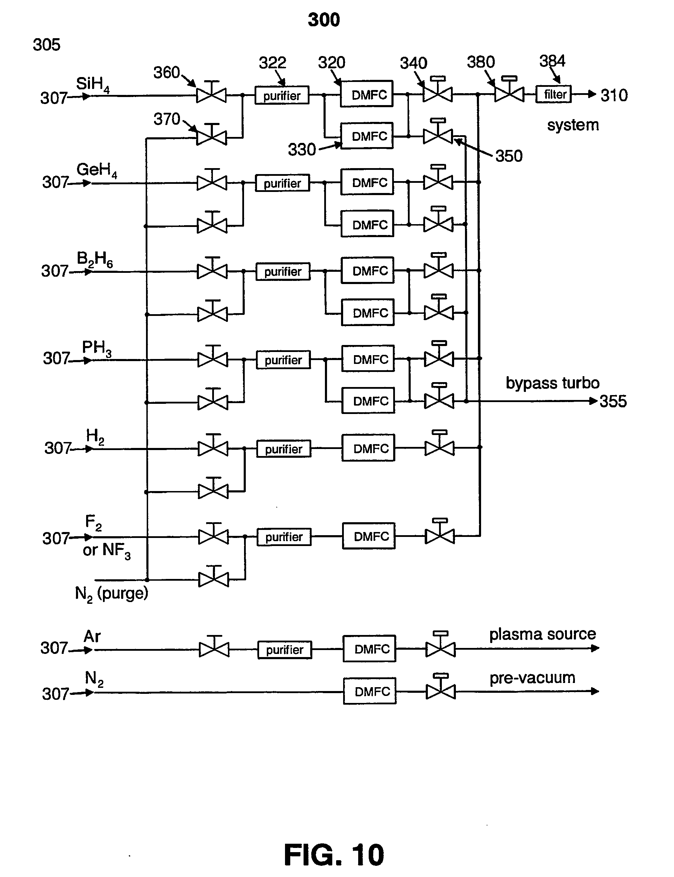

The following invention describes a fully computerized system 10 for low-energy plasma-enhanced chemical vapor deposition (LEPECVD). Referring to FIG. 1, the system 10 can be seen to comprise a plasma source 100, a deposition chamber 200; and a gas insertion manifold connected to a gas distribution system 300 (shown in detail in FIG. 10). The plasma generated in the plasma source 100 is based on a DC arc discharge described, for example, in US Patent No. 5,384,018 to Ramm et al. First uses of such a system 10 for the deposition of defect-free epitaxial Si and SiGe layers on Si have been described for example in US Patent No. 6,454,855 to von Känel et al. The system 10 allows scaling of the LEPECVD process to 300 mm wafers and beyond. Plasma parameters, gas flows, substrate heating and transfer are all computer controlled.

### A. Overview of the plasma source:

The basic operation of a low-voltage arc discharge has been explained for example in US Patent no. 5,384,018 to Ramm et al. for the case of a single thermionic cathode and a single orifice of the plasma source. The present invention differs in a number of fundamental aspects. First, the plasma source 100 contains more than one thermionic cathode 118, all of which can simultaneously be operated independently from one another. Second, the single orifice described for example in US Patent no. 5,384,018 to Ramm et al. is replaced by multiple orifices in the form of a shower head 116, such that the source acts as a broad area plasma source. Third, the configuration of the anode 210', 210" is substantially modified from the original ring-shape anode 210 described for example in US Patent no. 6,454,855 to von Känel et al., and in the international patent application no. WO 02/068710 by Wagner et al.

In the system 10 of the invention, it is explicitly shown that the methodology suggested in US Patent no. 5,384,018 to Ramm et al. can be applied to several thermionic cathodes 118 operated independently from one another. This has the advantage that higher arc currents can be attained without the need to increase either the cathode temperature or arc voltage.

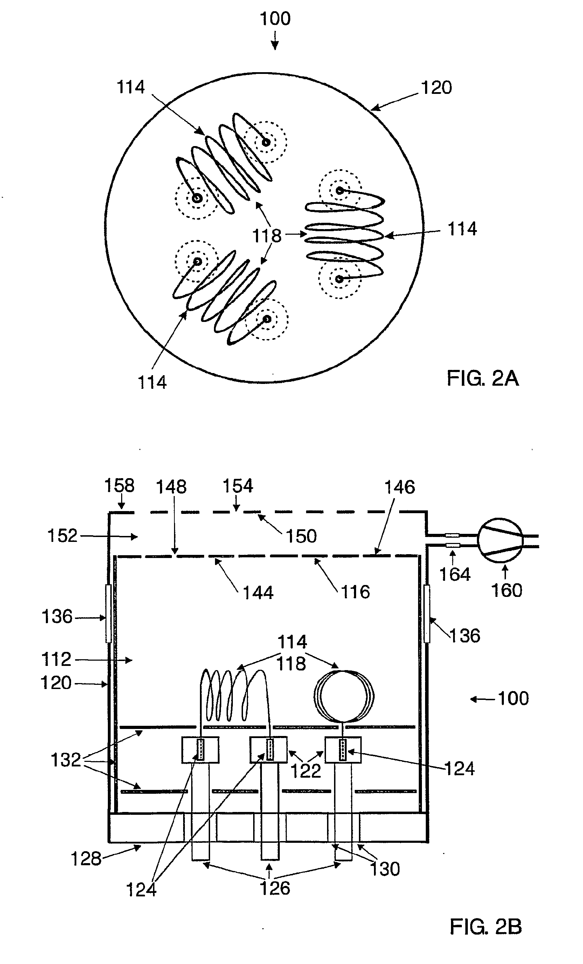

Referring now to FIG. 2, an embodiment is shown in which three cathodes are arranged in the form of Ta or W filaments 114 mutually insulated from each other and from the walls of the plasma source. The filaments 114 are mounted in tantalum sleeves 124 imbedded in molybdenum blocks 122 which are in intimate thermal and electrical contact with water-cooled copper rods 126. The latter are mounted on the bottom flange 128 by means of insulating feedthroughs 130. The bottom flange 128 is shielded against heat radiation from the filaments 114 by Mo or Ta shields 132. The entire cathode chamber is panelled by refractory metals 132, and electrically insulated from the deposition chamber 200 by means of insulators 136. The filaments 114 can be heated for example by an alternating current 140 (shown in FIG. 1 for one single filament connector 126).

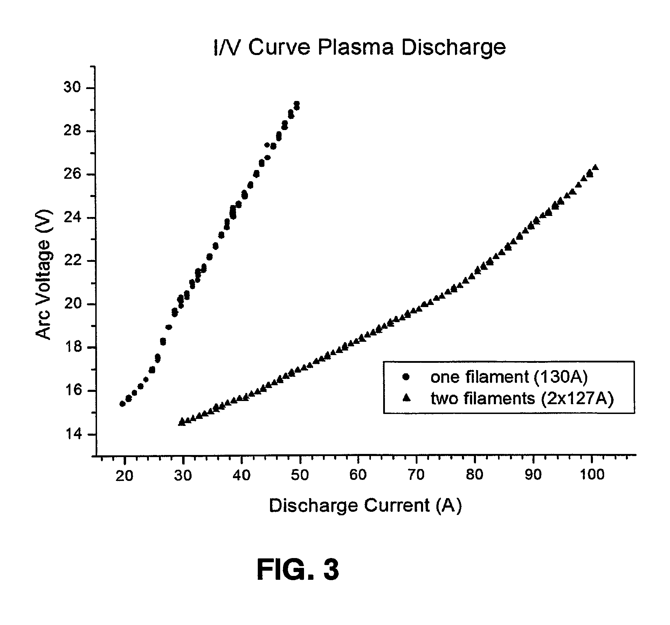

Referring now to FIG. 3, the effect of using more than one hot cathode 118 in the plasma source 100 on the current-voltage characteristics of the arc discharge is illustrated. The discharge gas Ar was injected into the plasma chamber 112, and no reactive gas was present in the deposition chamber 200. The current was adjusted to 127 A in each filament 114 made from a Ta wire having a length of 20 cm and a diameter of 2 mm. The arc current was varied by means of the DC power supply 142 in FIG. 1. For filament currents below 130 A, no evaporation could be detected during 200 h of continuous operation.

The simultaneous operation of two or more cathodes is shown to lead to a drastic decrease of the arc voltage necessary to sustain a given arc current. For example, with two cathodes 118 in the form of filaments 114 simultaneously operated, the arc voltage can be kept below 20 V for arc currents below 75 A. This is sufficiently low to exclude sputtering of any parts in the plasma source 100 and deposition chamber 200. With two filaments 114 and an arc current of 75 A, an average Si growth rate of 2 nm/s has been achieved on a 200 mm wafer at a silane flow as low as 30 sccm. For more than two cathodes 118 operated simultaneously, the reduction of arc voltage is even more dramatic such that arc currents above 150 A can easily be attained at arc voltages far below 30 V.

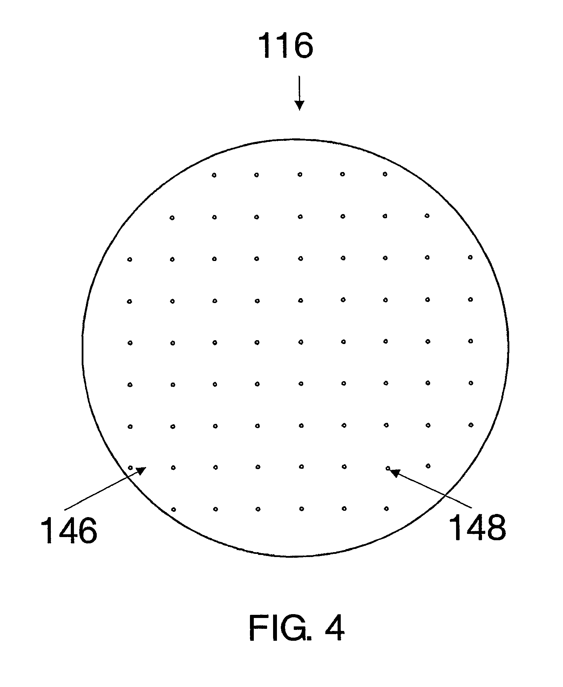

Referring now to FIG. 4, in the preferred embodiment of the invention, the plasma source 100 with the multiple cathodes 118 is capped with a diaphragm 144 in the form of a shower head 116 instead of the single orifice described for example in US Patent no. 5,384,018 to Ramm et al. It is advisable to provide temperature control to the shower head 116 and to cover the surface 146 facing the deposition chamber 200 with a corrosion resistant coating. The holes 148 of the showerhead 116 should be between 0.8 and 1.5 mm in diameter, preferably about 1 mm, and spaced at a nearest neighbour distance of 1- 3 cm.

The shower head 116 has a profound influence on the uniformity of the plasma column. The plasma uniformity was measured by moving a Langmuir probe across the plasma column and by measuring the floating potential (as a measure of the electron temperature) at intervals of 1 cm.

This procedure was carried out both on an LEPECVD system for 100 mm wafers (see for example US Patent no. to von Känel et al.) equipped with a source cover 144 having a single orifice (see for example US Patent no. 5,384,018 to Ramm et al.), as well as for a 200 mm system 10 featuring a plasma source 100 with the mentioned shower head 116. These measurements were done by translating the Langmuir probe along a line passing approximately through the center of the plasma column.

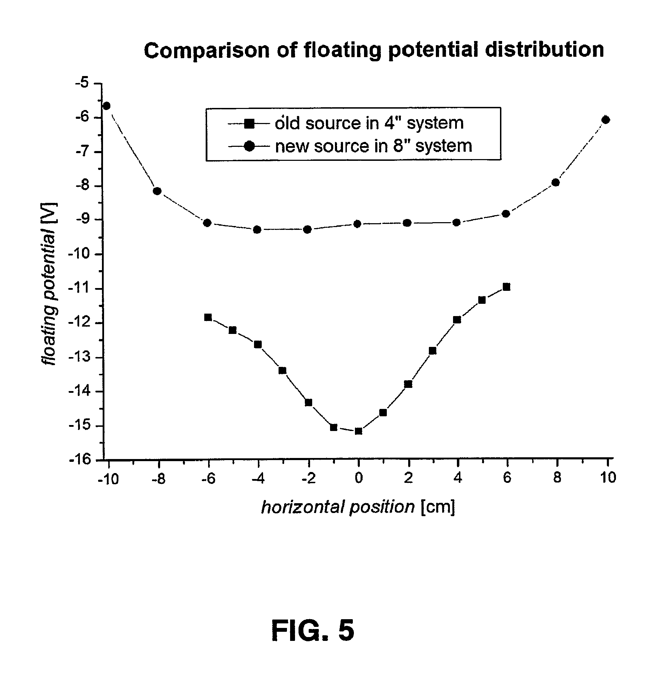

Referring now to FIG. 5, it is evident that the floating potential is much more uniform for the plasma source 100 with the shower head 116. This corresponds to a significantly more uniform plasma temperature and density in the latter case. It is important to notice that in these test experiments, the diameter of the shower head 116 was limited to about 130 mm. Too small a size of the shower head in comparison to the substrate size must be avoided if uniformity is to be achieved across the entire substrate area. This is evident from the rise of the plasma potential at the edges of the plasma column as shown in the graph of FIG. 5. The uniformity of the plasma can be extended across the width of the entire substrate by increasing the size of the shower head 116.

In another embodiment of the invention, corrosion resistance of the plasma source 100 is improved by placing a preferably water cooled diaphragm 150 with a corrosion resistant coating 158 facing the deposition chamber 200 above diaphragm 144. The holes 154 in diaphragm 150 have to be carefully aligned with the holes 148 in diaphragm 144. The size of the holes 154 should be intermediate between the size of holes 148 in diaphragm 144 and holes 248', 248" in the anode 210', 210". Thus, the orifices increase in size from diaphragm 144 to diaphragm 154 to diaphragm 210', 210" and are all aligned. Diaphragm 150 can act either as an anode or just as a means to create an additional space 152 in front of the shower head 116. When it is desired that diaphragm 150 be acting as an anode, it may be electrically connected to the deposition chamber 200. In order not to act as an anode, diaphragm 150 should be insulated from the deposition chamber for example by insulators 164. The space 152 between the two diaphragms 150, 144 is preferably differentially pumped by a turbo molecular pump 160 in order to avoid back-streaming of reactive gases from the deposition chamber 200 of FIG. 1 into the plasma source 100. In the absence of gases in the deposition chamber 200 which are corrosive for the refractory metal diaphragm 144, the additional diaphragm 150 and the differential pumping 160 may be considered as optional.

### B. Deposition chamber:

Referring now again to FIG. 1, in a preferred embodiment of the invention, the deposition chamber 200 has a corrosion resistant inner surface 204 exposed to the plasma and can be temperature controlled. For chlorine chemistries, coating of the inner chamber wall 204 for example by tantalum, diamond or certain oxides may be advisable. For fluorine chemistries, other coatings are preferred, such as aluminium nitride or oxide.

A temperature controlled anode 210', 210" permeable to the plasma is preferably used to control the arc discharge (see FIG. 1).

A high uniformity lamp heater 220 is used to heat the Si substrates from the back. The Si substrate holder 250 does not contain any refractory or other metals which could corrode in a reactive gas atmosphere. The wafer is preferably left floating. Alternatively, its potential can be externally controlled by a power supply 230. The reactive gases are fed into the reactor by means of a gas dispersal ring 260 made for example of fused quartz or from a temperature controlled aluminium manifold coated with a corrosion resistant layer. The magnetic field coils 240 may help to shape the plasma, and to reduce its interaction with the chamber walls. Additional sets of magnetic field coils 240 are positioned at various heights of the deposition chamber 200 so as to improve magnetic field strength and uniformity. Furthermore, the possibility for rapidly changing the magnetic field provided by the coils 240 provides a means for changing the plasma density equally fast. Since the plasma density determines the growth rate to a large extent (see for example US Patent No. 6,454,855 to von Känel et al. ), the growth rate can be changed from several nm/s to Å/s within fractions of a second by switching from high to low plasma density.

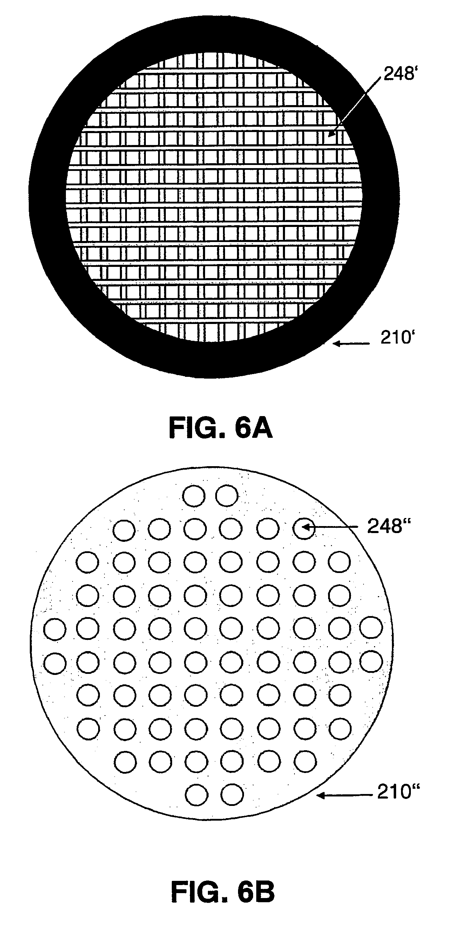

In the invention, the ring-shaped anode 210 described for example in US Patent no. 6,454,855 to von Känel et al., and in the International Patent Application no. WO 02/068710 by Ramm et al., is replaced by a preferably temperature controlled anode 210', 210" extending all across the plasma source 100 but being permeable to the plasma. This can be achieved for example by an anode in the shape of a grid 210' or a perforated plate 210" as schematically shown in FIG. 6A and 6B, respectively. For optimum performance the openings of the anode 248', 248"have to be carefully aligned with those in the shower head 148 and 154 such as not to shield the plasma emanating from the plasma source.

Optimum performance of the plasma source (100) - anode (210', 210") system has been observed when the anode (210', 210") has a distance in the range of 80-120 mm from the shower head (116).

The new anode geometry was found to improve dramatically the performance of the system in a number of ways.

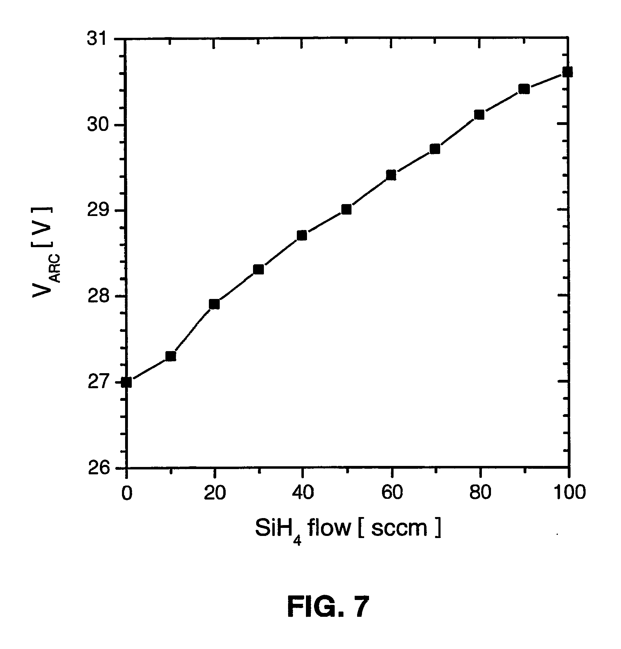

As can be seen in FIG. 7, the arc voltage rises only gradually when silane is added to an Ar plasma discharge. Just as importantly, the plasma discharge remains stable up to the highest silane flows permitted by the capacity of the mass flow controllers, in the experimental set-up limited to 100 sccm. In contrast, with all controllable parameters fixed, the plasma was found to become unstable at a silane flow of less than 10 sccm upon replacing the permeable anode by a conventional anode ring.

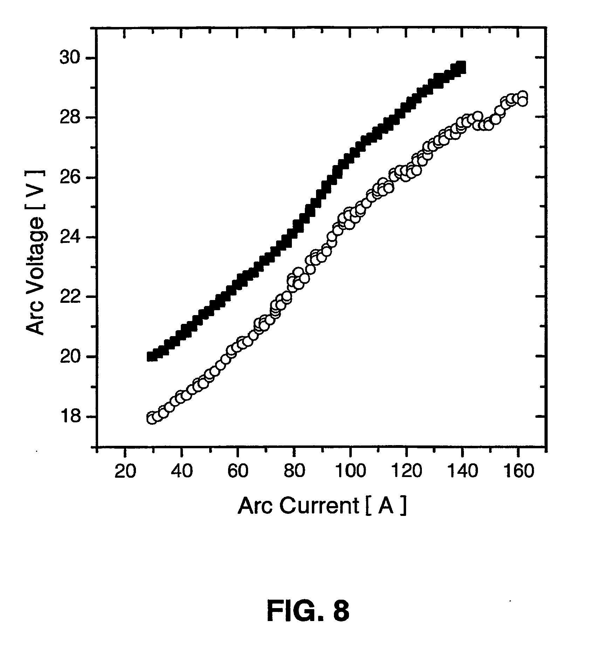

Alternatively, variations of the magnetic field confinement of the plasma have a minor effect on the arc current-voltage curves and none on the plasma stability. This can be seen in FIG. 8 showing V_{arc} vs. I_{arc} for two magnetic field configurations differing in magnetic field strength by about a factor of 2.

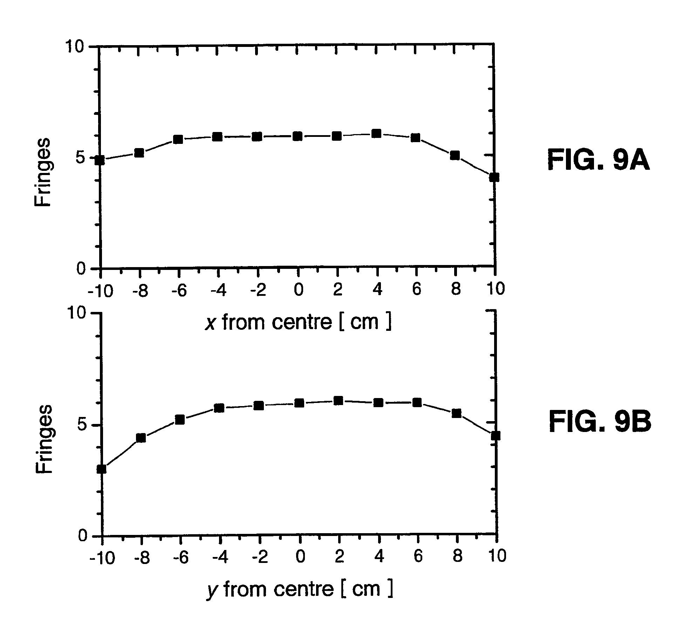

Most importantly, optical interference microscopy of step heights (FIG. 9) have shown that for a shower head 130 mm in diameter the thickness variation of a Si layer measured along two perpendicular directions on a 200 mm wafer amounts to ± 4% across the central area of the size of the source or ± 17% across the entire wafer. This is in accordance with the measured uniformity of the plasma column shown in FIG. 5. The measured thickness uniformity has been achieved without adding a lateral magnetic field component for wobbling the plasma column, which would further enhance uniformity according to US Patent no. 6,454,855 to von Känel et al., and the International Patent Application no. WO 02/068710 by Ramm et al. In the experiment whose results are shown in graphical form in FIG. 9 a reactive gas flow of pure silane of 100 sccm has been used, giving rise to an average growth rate of 3.5 nm/s on a 200 mm wafer.

According to the invention, fast epitaxial deposition of films with uniform thickness becomes possible on substrates at least 300 mm in size, by using a sufficiently broad area plasma source 100 with shower head 116 in combination with a permeable anode 210', 210".

The broad area plasma source 100 with shower head 116 in combination with a perforated anode 210', 210" according to the invention may find applications outside the field of LEPECVD, for example in a low-energy ion implanter or, more generally, in the low-energy plasma treatment of surfaces.

### C. Gas distribution system:

Referring now to FIG. 10, the gas distribution system 300 provides for fast switching between high and low gas flows, and from one gas to another. It comprises a gas inlet 305 with gas lines 307 for 6 reactive gases and 2 inert gases N₂ and Ar. For the sake of rapid switching, high and low capacity digital mass flow controllers ("DMFC") 320 and 330, respectively, are connected in parallel for the important process gases, such as SiH₄, GeH₄ and PH₃:Ar, B₂H₆:Ar. The doping gases are typically diluted to 0.1 - 1 % in Ar. A steady gas flow is maintained through the mass flow controllers in order to avoid overshoots during switching. This is accomplished by gas-to-process-chamber, and gas-to-bypass valves 340 and 350, respectively, by means of which the gas flows can be directed either to the turbo-molecular pump 160, 355 or into the deposition chamber 200 via gas outlet 310. Rapid gas switching, in combination with rapid changes of the plasma density by activating the coils 240 in FIG. 1, makes it possible to attain abrupt interfaces by LEPECVD. Furthermore, the gas distribution system 300 includes main inlet valves 360, N₂ purge valves 370 and a main valve 380 for gas outlet 310 to the deposition chamber 200 .

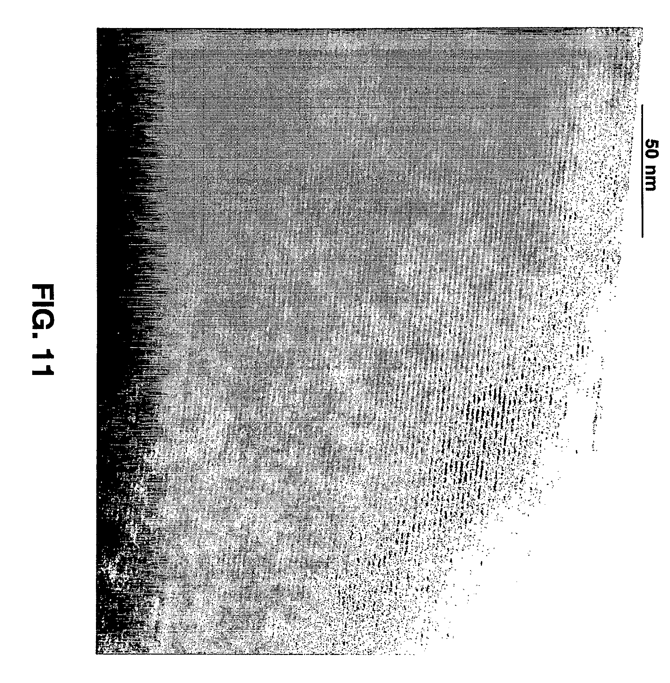

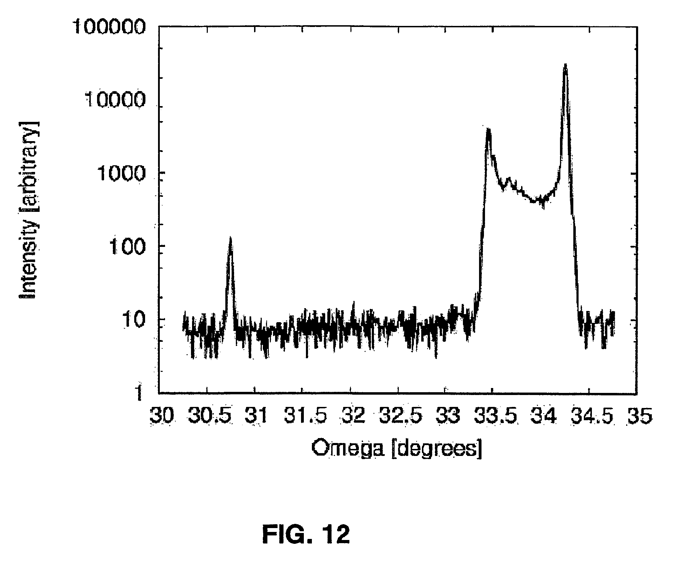

Referring now to FIG. 11, a transmission electron microscopy image of part of a 200 period Si/Ge superlattice (SL) demonstrates the excellent quality of deposition control. The period is only 1.9 nm, and the individual Si and Ge layer thickness 1 nm and 0.9 nm, respectively. The substrate temperature during growth of the SL was 450° C. During SL growth, 10 sccm of H₂ was supplied to the gas phase in order to suppress strain-enhanced segregation and buckling of the layers. The SL was grown on top of a SiGe buffer layer, linearly graded to a final Ge content of 50 % and capped with one micrometer of constant composition material. Referring now to FIG. 12, this can be seen also from the ω-2θ X-ray scan around the (004) reflection. This figure shows the continuous intensity between the Si substrate peak and the alloy layer peak due to the grading, and, in addition, the first order superlattice reflection at lower angles. Since the SL is grown on a relaxed buffer with nearly the same average composition, the individual Si and Ge layers are almost symmetrically strained.

### D. Chamber self-cleaning:

In the preferred embodiment of the invention, the system 10 is equipped with at least one gas line for chamber cleaning in addition to the gas lines 307 for reactive gases used for depositing semiconductor material. In this application the arc discharge is used to generate the low energy ions and radicals for example of fluorine containing gases such as F₂ or NF₃ or of chlorine containing gases. The corrosion resistant coatings 204, 146, and 158 of the deposition chamber walls 204 and of the plasma source/anode assembly 144/210', 210" or 150/210', 210" is chosen in accordance with the choice of chamber cleaning chemistry, as described in Sections A and B, above. For fluorine chemistries, coatings for example of aluminium nitride or aluminium oxide are preferably used, while for chlorine chemistries for example tantalum, diamond or rare earth oxides may be advisable.

In contrast to prior art *in-situ* plasma, cleaning by LEPECVD does not involve any bombardment of the chamber walls by high-energy ions. This obviates the need for a separate remote plasma source for chamber cleaning, as described for example by Raoux et al. in J. Vac. Sci. Technol. B 17, 477 (1999).

### E. Selective epitaxial growth:

In a preferred embodiment of the invention, the temperature controlled deposition chamber 200 is based on aluminium or stainless steal containers with appropriate corrosion resistant coatings such as oxides or nitrides. This, in addition to substrate heating by lamps, is furthermore compatible with the use of chlorine or fluorine containing reactive gases for example for SiGe deposition. The concepts developed for selective epitaxial growth (SEG) in other CVD reactors can therefore be easily translated to an LEPECVD system according to the invention.

Preferrably, a Si wafer (not shown) with a patterned oxide or nitride mask (not shown) is subjected to a flux of dichlorosilane (DCS) in the presence of a low-energy plasma. The DCS flux may be supplemented by fluxes of chlorine and hydrogen or of HCl.

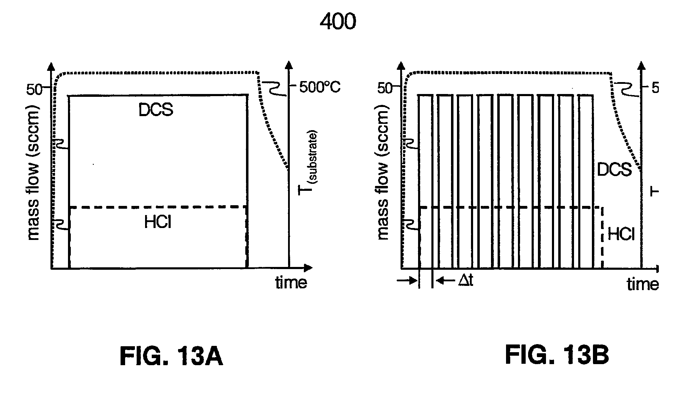

Referring now to FIG. 13A and 13B, the Si-containing gases may be supplied continuously or in a pulsed fashion, respectively, whereby the window of substrate temperatures over which SEG is observed may be substantially enlarged. In a preferred embodiment, the substrate, covered with a patterned oxide or nitride mask, is heated to a temperature above 500° C. DCS and HCl gases are introduced at a mass flow in between 1 and 50 sccm each.

Use of the pulsed mode is advisable when large layer thickness is to be achieved. In this mode, the DCS flow is interrupted after a delay time Δt while HCl keeps flowing. Simultaneously with the interruption of the DCS flow the plasma parameters may be changed. In a preferred embodiment, the plasma density is increased during pure HCl flow in order to speed up the etching of small Si islands which may have nucleated on the mask. This procedure of DCS interruption and plasma parameter change is repeated until the desired thickness of epitaxial silicon in the unmasked areas is reached. The delay time Δt can be increased with increasing substrate temperature.

In another embodiment of the invention pure DCS and germane are used as reactive gases. Their flux may be supplemented by fluxes of chlorine and hydrogen or of HCl. The substrate is heated to a temperature above 500° C. A mass flow of DCS and germane is then established along with an excess mass flow of HCl, either continuously or in a pulsed fashion. In a preferred embodiment of the invention the substrate, covered with a patterned oxide or nitride mask, is heated to a temperature above 500° C. DCS, germane and HCl gases are introduced at a mass flow in between 1 and 50 sccm each.

Use of the pulsed mode is advisable when large layer thickness is to be achieved. In this mode, the DCS and germane flows are interrupted after a time delay Δt while HCl keeps flowing. Simultaneously with the interruption of the DCS and germane flows, the plasma parameters may be changed. In a preferred embodiment, the plasma density is increased during pure HCl flow in order to speed up the etching of small SiGe islands which may have nucleated on the mask. This procedure of DCS interruption and plasma parameter change is repeated until the desired thickness of epitaxial silicon-germanium in the unmasked areas is reached. The delay time Δt can be increased with increasing substrate temperature.

The system 10 of the invention enables a method 400 of low-energy plasma enhanced CVD in which selective epitaxial growth is achieved by using chlorinated precursor gases. Such method 400 operates at least two cathodes 118 simultaneously, thereby significantly reducing an arc voltage necessary to sustain a given arc current. Using the method 400, the plasma density at the substrate, combined with fast gas switching, as described herein, enables fast switching from high to low growth rates.

In an advantage of the invention, a plasma source 100 is provided which is capable of generating a very low-voltage, high current arc discharge, without the need to use excessive cathode temperatures.

In another advantage of the invention, a plasma source 100 is provided which is capable of a homogeneous plasma density and electron temperature across a substrate up to 300 mm in size.

In another advantage of the invention, an anode geometry is provided which allows for stable high-current discharge in the presence of reactive gases.

In another advantage of the invention, a plasma-source/anode combination 100/210', 210" is provided which is suitable also for application in low-energy ion implantation.

In another advantage of the invention, a LEPECVD system 10 is provided for epitaxial semiconductor deposition compatible with the process of reactor chamber cleaning.

In another advantage of the invention, a system 10 is provided which allows for the use of halogenated precursors in an LEPECVD process.

In another advantage of the invention, a low-energy plasma is provided which is suitable for surface treatment processes.

Multiple variations and modifications are possible in the embodiments of the invention described here. Although certain illustrative embodiments of the invention have been shown and described here, a wide range of modifications, changes, and substitutions is contemplated in the foregoing disclosure. In some instances, some features of the present invention may be employed without a corresponding use of the other features. For example, although the illustrations provided for the present embodiments of the invention relate to Si and Ge containing materials, the invention is equally applicable to other materials systems, such as for example GaN and SiC. Accordingly, it is appropriate that the foregoing description be construed broadly and understood as being given by way of illustration and example only, the scope of the invention being limited only by the appended claims.

## Claims

1. A system (10) for low-energy plasma-enhanced chemical vapour deposition suitable for the epitaxial growth of uniform semiconductor layers on substrates 300 mm in size, the system comprising:
(a) a broad-area plasma source (100);
(b) a deposition chamber (200); and
(c) a gas distribution system (300),
wherein the plasma source (100) comprises an enclosure (120), at least two thermionic cathodes (118) adapted to be operated independently from one another and enclosed in a cathode chamber, and a shower head (116) having a plurality of orifices (148); and wherein the deposition chamber (200) is equipped with an anode (210', 210") having orifices (248', 248") making the anode permeable to the plasma and mounted between the shower head of the plasma source and the substrate holder (250), wherein said orifices (248', 248") of the anode (210', 210") and said orifices (148) of the shower head (116) are aligned.

2. The system (10) of claim 1, wherein the orifices (148) are distributed over an area which approximates in size the area of substrate on which the deposition is to occur.

3. The system (10) of claim 1, wherein the orifices (248', 248") are evenly distributed over the area approximating the area of the substrate on which the deposition is to occur.

4. The system (10) of claim 1, wherein the plasma source (100)
(a) is equipped with at least one electrode (150) in front of the shower head (116), said electrode being permeable to the plasma and capable of acting as an anode;
(b) is adaptable to low-energy ion implantation; and
(c) is adaptable to low-energy plasma treatment of surfaces.

5. The system (10) of claim 1, wherein the shower head (116) is temperature controlled and has a corrosion resistant coating on the surface (146) facing the deposition chamber (200).

6. The system (10) of claim 1, wherein the plasma source (100) has a liquid cooled diaphragm (150) above a refractory metal diaphragm (144), and whereby diaphragm (150) with a plurality of orifices (154) is temperature controlled and has a corrosion resistant coating on the surface (146) facing the deposition chamber (200), and whereby diaphragm (150) is electrically insulated from system ground by insulators (164).

7. The system (10) of one of claim 6, wherein the orifices increase in size from the refractory metal diaphragm (144) to the additional liquid cooled diaphragm (150) to anode diaphragm (210', 210") and are all aligned.

8. The system (10) of any of claims 1-7, wherein the walls of the deposition chamber (200) are temperature controlled and covered with a corrosion resistant coating on an inner surface (204) which, in use, is exposed to the plasma.

9. The system (10) of any of claims 1-8, wherein the anode (210', 210") is temperature controlled and covered with a corrosion resistant coating.

10. The system (10) of claim 1, wherein the plasma source (100) has cathodes (118) arranged as Ta or W filaments (114) mutually insolated from each other and from the enclosure (120) of the plasma source (100).

11. The system (10) of claim 10, wherein the plasma source (100) has filaments (114) mounted on tantalum sleeves (124) imbedded in molybdenum blocks (122).

12. The system (10) of claim 11, wherein the molybdenum blocks (122) of the plasma source (100) are in intimate thermal and electrical contact with water-cooled copper rods (126).

13. The system (10) of claim 12, wherein the plasma source (100) comprises copper rods (126) mounted on a flange (128) via insulating feedthroughs (130).

14. The system (10) of claim 13, wherein the plasma source (100) has the flange (128) which is shielded against heat radiation from the filaments by Mo or Ta shields (132).

15. The system (10) of any of the above claims, wherein the cathode chamber (112) is empanelled by refractory metals (132) and electrically insulated from the deposition chamber via insulators (136).

16. The system (10) of claim 6, wherein a space (152) separating the diaphragms (144, 150) is differentially pumped by a turbo molecular pump (160) in order to avoid back-streaming of reactive gases into the source.

17. The system (10) of claim 1, further comprising a fast switching mechanism (300) enabling fast switching from high to low growth rates.

18. The system (10) of claim 1, wherein the deposition /reactor chamber (200) comprises a self-cleaning mechanism using cleaning agents comprising ions and radicals generated from halogen gases, such as fluorine or chlorine, in the high-density low-energy plasma available in LEPECVD.

19. A method (400) of low-energy plasma enhanced CVD using the system (10) of claim 1, wherein selective epitaxial growth is achieved by using chlorine containing precursor gases.

20. A method (400) of low-energy plasma enhanced CVD using the system (10) of claim 1, wherein the at least two cathodes (118) are operated simultaneously, thereby significantly reducing an arc voltage necessary to sustain a given arc current.

21. The method (400) of claim 20, wherein plasma density at the substrate, combined with fast gas switching, enables fast switching from high to low growth rates.

## Patentansprüche

1. System (10) zur energiearmen, plasmagestützten chemischen Gasphasenabscheidung, die für das epitaxiale Wachstum von einheitlichen Halbleiterschichten auf Substraten von 300 mm Größe geeignet ist, wobei das System Folgendes umfasst:
(a) eine bereichsumfassende Plasmaquelle (100);
(b) eine Abscheidungskammer (200); und
(c) ein Gasverteilersystem (300),
wobei die Plasmaquelle (100) ein Gehäuse (120) umfasst, wenigstens zwei thermionische Kathoden (118) die derart adaptiert sind, um unabhängig voneinander betrieben zu werden, und in einer Kathodenkammer eingeschlossen ist sowie einen Duschkopf (116) mit einer Vielzahl von Öffnungen (148) und wobei die Verteilerkammer (200) mit einer Anode (210', 210") ausgerüstet ist, die Öffnungen (248', 248") aufweist, wodurch die Anode für Plasma durchgängig wird, und zwischen dem Duschkopf der Plasmaquelle und dem Substrathalter (250) befestigt ist, wobei die genannten Öffnungen (248', 248") der Anode (210', 210") und die genannten Öffnungen (148) des Duschkopfes (116) miteinander ausgerichtet sind.

2. System (10) nach Anspruch 1, wobei die Öffnungen (148) über einem Bereich verteilt sind, der die ungefähre Größe des Substratbereichs aufweist, auf dem die Abscheidung stattfinden soll.

3. System (10) nach Anspruch 1, wobei die Öffnungen (248', 248") über dem Bereich gleichmäßig verteilt sind, der ungefähr dem Bereich des Substrats entspricht, auf dem die Abscheidung stattfinden soll.

4. System (10) nach Anspruch 1, wobei die Plasmaquelle (100)
(a) mit wenigstens einer Elektrode (150) vor dem Duschkopf (116) ausgerüstet ist, wobei die genannte Elektrode für das Plasma durchgängig ist und in der Lage ist, als eine Anode zu fungieren;
(b) für eine energiearme Ionenimplantation adaptierbar ist; und
(c) für eine energiearme Plasmabehandlung der Oberflächen adaptierbar ist.

5. System (10) nach Anspruch 1, wobei der Duschkopf (116) temperaturgesteuert ist und eine korrosionsbeständige Beschichtung auf der Oberfläche (146) aufweist, welche der Abscheidungskammer (200) gegenüberliegt.

6. System (10) nach Anspruch 1, wobei die Plasmaquelle (100) eine flüssigkeitsgekühlte Membrane (150) über einer Membrane (144) aus feuerfestem Metall aufweist und wobei die Membrane (150) mit einer Vielzahl von Öffnungen (154) temperaturgesteuert wird und eine korrosionsbeständige Beschichtung auf der Oberfläche (146) aufweist, welche der Abscheidungskammer (200) gegenüberliegt und wobei die Membrane (150) elektrisch gegenüber der Systemerdung durch Isolatoren (164) isoliert ist.

7. System (10) nach Anspruch 6, wobei sich die Größe der Öffnungen von der Membrane (144) aus feuerfestem Metall an zur zusätzlichen flüssigkeitsgekühlten Membrane (150) hin bis zur Anodenmembrane (210', 210") hin erhöht und alle miteinander ausgerichtet sind.

8. System (10) nach einem der Ansprüche 1 - 7, wobei die Wände der Abscheidungskammer (200) temperaturgesteuert sind und mit einer korrosionsbeständigen Beschichtung an der inneren Oberfläche (204) beschichtet sind, welche bei Gebrauch dem Plasma ausgesetzt ist.

9. System (10) nach einem der Ansprüche 1 - 8, wobei die Anode (210', 210") temperaturgesteuert und mit einer korrosionsbeständigen Beschichtung beschichtet ist.

10. System (10) nach Anspruch 1, wobei die Plasmaquelle (100) Kathoden (118) aufweist, die als Ta- oder W-Filamente (114), die gemeinsam gegenseitig und gegenüber dem Gehäuse (120) der Plasmaquelle (100) isoliert sind, angeordnet sind.

11. System (10) nach Anspruch 10, wobei die Plasmaquelle (100) Filamente (114) aufweist, die an Tantal-Manschetten (124) befestigt sind, welche in Molybdän-Blöcken (122) eingebettet sind.

12. System (10) nach Anspruch 11, wobei die Molybdän-Blöcke (122) der Plasmaquelle (100) in engem thermischen und elektrischen Kontakt mit wassergekühlten Kupferstäben (126) stehen.

13. System (10) nach Anspruch 12, wobei die Plasmaquelle (100) Kupferstäbe (126) umfasst, die an einem Flansch (128) über isolierende Durchführungen (130) befestigt sind.

14. System (10) nach Anspruch 13, wobei die Plasmaquelle (100) einen Flansch (128) aufweist, der durch Mo- oder Ta-Schirme (132) gegen Hitzestrahlung von den Filamenten abgeschirmt ist.

15. System (10) nach einem der vorstehenden Ansprüche, wobei die Kathodenkammer (112) durch feuerfeste Metalle (132) eingetafelt und gegenüber der Abscheidungskammer über Isolatoren (136) isoliert ist.

16. System (10) nach Anspruch 6, wobei ein Raum (152), der die Membranen (144, 150) trennt, differenzial durch eine Turbomolekularpumpe (160) gepumpt wird, um eine Rückströmung reaktiver Gase in die Quelle zu vermeiden.

17. System (10) nach Anspruch 1, ferner umfassend einen Schnellschaltungsmechanismus (300), der eine schnelle Schaltung von hohen bis zu niedrigen Wachstumsraten ermöglicht.

18. System (10) nach Anspruch 1, wobei die Abscheidungs- /Reaktorkammer (200) unter Anwendung von Reinigungsmitteln, die lone und Radikale umfassen, die aus Halogengasen, wie z.B. Fluor und Chlor, erzeugt werden, einen selbstreinigenden Mechanismus im hochverdichteten, energiearmen Plasma, das in LEPECVD zur Verfügung steht, umfasst.

19. Verfahren (400) einer energiearmen, plasmagestützten CVD unter Anwendung des Systems (10) nach Anspruch 1, wobei das selektive epitaxiale Wachstum unter Anwendung von Chlor enthaltenden Vorläufergasen erreicht wird.

20. Verfahren (400) einer energiearmen, plasmagestützten CVD unter Anwendung des Systems (10) nach Anspruch 1, wobei die wenigstens zwei Kathoden (118) gleichzeitig betrieben werden, wodurch die zur Beibehaltung eines bestimmten Lichtbogenstroms erforderliche Lichtbogenspannung dadurch erheblich reduziert wird.

21. Verfahren (400) nach Anspruch 20, wobei die Plasmadichte am Substrat, kombiniert mit einer schnellen Gasschaltung, die schnelle Schaltung von hohen bis zu niedrigen Wachstumsraten ermöglicht.

## Revendications

1. Système (10) de dépôt chimique en phase vapeur activé par plasma de faible énergie pour la croissance épitaxiale de couches semi-conductrices uniformes sur des substrats ayant une dimension de 300 mm, le système comprenant :
(a) une source de plasma (100) à surface étendue ;
(b) une chambre de dépôt (200) ; et
(c) un système de distribution de gaz (300),
dans lequel la source de plasma (100) comprend une enceinte (120), au moins deux cathodes thermioniques (118) adaptées pour être excitées indépendamment l'une de l'autre et enfermées dans une chambre cathodique, et une pomme de douche (116) ayant une pluralité d'orifices (148) ; et dans lequel la chambre de dépôt (200) est équipée d'une anode (210', 210") ayant des orifices (248', 248") rendant l'anode perméable au plasma et montée entre la pomme de douche de la source de plasma et le support de substrat (250), dans lequel lesdits orifices (248', 248") de l'anode (210', 210") et lesdits orifices (148) de la pomme de douche (116) sont alignés.

2. Système (10) selon la revendication 1, dans lequel les orifices (148) sont répartis sur une surface dont la dimension approche celle de la surface du substrat sur laquelle le dépôt doit être effectué.

3. Système (10) selon la revendication 1, dans lequel les orifices (248', 248") sont répartis de manière régulière sur la surface approchant la surface du substrat sur laquelle le dépôt doit être effectué.

4. Système (10) selon la revendication 1, dans lequel la source de plasma (100)
(a) est équipée d'au moins une électrode (150) en face de la pomme de douche (116), ladite électrode étant perméable au plasma et capable d'agir comme une anode ;
(b) est adaptable à une implantation ionique de faible énergie ; et
(c) est adaptable à un traitement de surfaces par plasma de faible énergie.

5. Système (10) selon la revendication 1, dans lequel la pomme de douche (116) est régulée en température et possède un revêtement résistant à la corrosion sur la surface (146) faisant face à la chambre de dépôt (200).

6. Système (10) selon la revendication 1, dans lequel la source de plasma (100) possède un diaphragme refroidi par liquide (150) au-dessus d'un diaphragme en métal réfractaire (144), et dans lequel le diaphragme (150) avec une pluralité d'orifices (154) est régulé en température et possède un revêtement résistant à la corrosion sur la surface (146) faisant face à la chambre de dépôt (200), et dans lequel le diaphragme (150) est isolé électriquement de la masse du système par des isolants (164).

7. Système (10) selon la revendication 6, dans lequel les orifices augmentent en taille du diaphragme de métal réfractaire (144) au diaphragme refroidi par liquide complémentaire (150) jusqu'au diaphragme de l'anode (210', 210") et sont tous alignés.

8. Système (10) selon l'une quelconque des revendications 1 à 7, dans lequel les parois de la chambre de dépôt (200) sont régulées en température et couvertes d'un revêtement résistant à la corrosion sur une surface interne (204) qui, en cours d'utilisation, est exposée au plasma.

9. Système (10) selon l'une quelconque des revendications 1 à 8, dans lequel l'anode (210', 210") est régulée en température et couverte d'un revêtement résistant à la corrosion.

10. Système (10) selon la revendication 1, dans lequel la source de plasma (100) possède des cathodes (118) agencées comme des filaments Ta ou W (114) mutuellement isolés l'un de l'autre et de l'enceinte (120) de la source de plasma (100).

11. Système (10) selon la revendication 10, dans lequel la source de plasma (100) possède des filaments (114) montés sur des manchons de tantale (124) logés dans des blocs de molybdène (122).

12. Système (10) selon la revendication 11, dans lequel les blocs de molybdène (122) de la source de plasma (100) sont en contact thermique et électrique intime avec des tiges de cuivre refroidies à l'eau (126).

13. Système (10) selon la revendication 12, dans lequel la source de plasma (100) comprend des tiges de cuivre (126) montées sur un rebord (128) via des traversées isolantes (130).

14. Système (10) selon la revendication 13, dans lequel la source de plasma (100) présente le rebord (128) qui est protégé contre le rayonnement thermique des filaments par des blindages de Mo et Ta (132).

15. Système (10) selon l'une quelconque des revendications précédentes, dans lequel la chambre cathodique (112) est constituée par des métaux réfractaires (132) et isolée électriquement de la chambre de dépôt par le biais d'isolants (136).

16. Système (10) selon la revendication 6, dans lequel un espace (152) séparant les diaphragmes (144, 150) est pompé différentiellement par une pompe turbomoléculaire (160) afin d'éviter un flux de retour de gaz réactifs dans la source.

17. Système (10) selon la revendication 1, comprenant en outre un mécanisme de commutation rapide (300) permettant une commutation rapide d'un faible taux de croissance à un taux de croissance élevé.

18. Système (10) selon la revendication 1, dans lequel la chambre de dépôt/de réaction (200) comprend un mécanisme autonettoyant utilisant des agents de nettoyage comprenant des ions et des radicaux générés à partir de gaz halogènes, tels que fluor et chlore, dans le plasma de faible énergie et haute densité disponible chez LEPECVD.

19. Procédé (400) de dépôt chimique en phase vapeur de faible énergie utilisant le système (10) selon la revendication 1, dans lequel la croissance épitaxiale sélective est obtenue en utilisant des gaz précurseurs contenant du chlore.

20. Procédé (400) de dépôt chimique en phase vapeur activé par plasma de faible énergie utilisant le système (10) selon la revendication 1, dans lequel les au moins deux cathodes (118) sont excitées simultanément, réduisant ainsi de façon significative une tension d'arc nécessaire pour soutenir un courant d'art donné.

21. Procédé (400) selon la revendication 20, dans lequel la densité de plasma au niveau du substrat, combinée à la commutation de gaz rapide, permet une commutation rapide des taux de croissance élevé à faible.
